# EUROPEAN PATENT SPECIFICATION

(11) **EP 4 175 172 B1**
(45) Date of publication and mention of the grant of the patent: **22.07.2026**
(21) Application number: 21205479.5
(22) Date of filing: 29.10.2021
(51) Int. Cl.: H03K 3/537, H01T 11/00

(54) **A HIGH VOLTAGE PULSE GENERATOR AND A METHOD OF OPERATING A HIGH VOLTAGE PULSE GENERATOR**
HOCHSPANNUNGSIMPULSGENERATOR UND VERFAHREN ZUM BETRIEB EINES HOCHSPANNUNGSIMPULSGENERATORS
GÉNÉRATEUR D'IMPULSIONS HAUTE TENSION ET PROCÉDÉ DE FONCTIONNEMENT D'UN GÉNÉRATEUR D'IMPULSIONS HAUTE TENSION

(43) Date of publication of application: 03.05.2023
(73) Proprietor: VITO NV, 2400 Mol (BE)
(72) Inventor: COENEN, Peter, 2400 Mol (BE); VAN DE POL, Nico, 2400 Mol (BE); HEREMANS, Guido, 2400 Mol (BE); JANSSEN, Stijn, 2400 Mol (BE)
(74) Representative: V.O.

(56) References cited:
- DE-A1- 102005 025 998
- US-A- 3 867 663
- US-A1- 2006 061 932
- REDONDO L M ET AL: "High-voltage high-frequency Marx-bank type pulse generator using integrated power semiconductor half-bridges", POWER ELECTRONICS AND APPLICATIONS, 2005 EUROPEAN CONFERENCE ON DRESDEN, GERMANY 11-14 SEPT. 2005, PISCATAWAY, NJ, USA,IEEE, PISCATAWAY, NJ, USA, 11 September 2005 (2005-09-11), pages P.1 - P.8, XP010933703, ISBN: 978-90-75815-09-2, DOI: 10.1109/EPE.2005.219301

## Description

### FIELD OF THE INVENTION

The invention relates to a high voltage Marx generator. Furthermore, the invention relates to a method of operating a high voltage Marx generator.

### BACKGROUND TO THE INVENTION

A Marx generator is an electrical circuit for producing high voltage pulses. Such high voltage pulse generators have a particular circuit topology and are widely used in various applications. Conventionally, a Marx generator includes a plurality of stages (cf. circuit branches) each consisting of an energy storage capacitor and a switch. The capacitors are charged in parallel by a charging voltage and then discharged in series by means of the switches, producing a high voltage pulse. During discharge, the generator can deliver its energy to a load that can be resistive, inductive, and/or capacitive. The Marx generator is configured to generate high voltage pulses having voltages greater than the voltage of its power supply. Such high voltage generators may have numerous possible applications, such as for instance electro-pulse drilling.

Typically, the Marx generator includes a plurality of capacitor stages. The spark gaps in the stages may operate in a self-breakdown mode. To each spark gap, except for the output spark gap, two charging branches are connected, one to each of the two connectors of the spark gap. As a result, there are altogether 2(n-1) charging branches associated with an n-stage Marx generator. With a charging voltage U at each of the stage capacitors at the output of the Marx generator, a voltage pulse with a peak value of n*U can be obtained at breakdown. For example, a 100 stage Marx Generator that is charged to 10 kV per stage can produce approximately 1,000 kV at the load. Likewise, a 10 stage Marx that is charged to 100 kV per stage will produce approximately the same voltage at the load.

The switches in the Marx generator are typically gas insulated spark gaps that are constructed of two principal electrodes. The Marx generator may comprise a housing in which an atmosphere of a dielectric gas prevails. The plurality of capacitor stages may be arranged in said housing.

DE102005025998 describes a method for the continuous, triggered operation of a Marx generator for pressure control and combustion detection in the spark gaps.

US20060061932 describes a trigger arrangement for a Marx generator.

US3867663 describes a spark gap device that adjusts electrode spacing and gas pressure using a single control for enabling varied breakdown voltages.

### SUMMARY OF THE INVENTION

It is an object of the invention to provide for a method and a system that obviates at least one of the above mentioned drawbacks.

Additionally or alternatively, it is an object of the invention to improve the operation of the Marx generator.

Additionally or alternatively, it is an object of the invention to improve a self-breakdown of spark gaps in a Marx generator.

Additionally or alternatively, it is an object of the invention to prevent over-voltage and/or under-voltage breakdown of one or more spark gaps in a Marx generator.

Additionally or alternatively, it is an object of the invention to reduce wear generated by an over-voltage breakdown of one or more spark gaps.

Additionally or alternatively, it is an object of the invention to maintain the output of the Marx generator within a predetermined range at predetermined points in time, particularly with regard to repetitive operations.

Thereto, the invention provides for a Marx generator according to independent claim 1 comprising a circuit which includes at least two capacitors which are arranged to be charged in parallel and to be discharged in series, wherein during discharge an output voltage is generated adding up a charging voltage of each of the at least two capacitors, wherein the circuit comprises at least two spark gap switches, wherein each spark gap switch comprises two electrodes separated by a gap distance which is filled with a pressurized gas, and wherein each spark gap switch is configured to allow an electric spark to pass between its two electrodes in case a potential difference between said two electrodes exceeds a breakdown voltage, and wherein the Marx generator includes a compensation unit which is configured to compensate for effects resulting from changes in pressure of the pressurized gas.

The control method and system according to the invention provides an advantageous way for controlling the operation of the Marx generator by taking into account pressure changes in the pressurized gas surrounding the electrodes of the spark gap switches.

Advantageously, a stable output power can be better guaranteed. The output power/energy may be substantially constant or within a predetermined range, for example +-2 percent, +-5 percent, +-10 percent. This may be of great importance for various applications, such as for instance electro-pulse drilling heads employing a Marx generator. When drilling with an electro-pulse drill head, it may be desirable to drill continuously with the same energy. For example, if the pressure of the pressurized gas drops (due to any circumstances/effects), the capacitors in the Marx generator circuit may not charge to sufficiently high levels, since the spark gap switches will trigger/break earlier. For example, if the pressure drops due to circumstances, no spark may be generated between the electrodes of the spark gaps at a desired breakdown voltage, but at breakdown voltage which is substantially lower (e.g. 20kV instead of a desired 40kV, which would result in a quarter of the energy output). According to the disclosure, a control system can be provided which can actively compensate for the effects resulting in deviations in pressure of the pressurized gas in such a way that when pressure changes (e.g. pressure reduction), it still triggers at the desired breakdown voltage.

Optionally, the compensation unit is configured to ensure that the breakdown voltage for each of the spark gap switches is kept within in a certain range, preferably within +-10 percent of a target value, more preferably within +-15 percent of a target value, even more preferably within +-20 percent of a target value. Optionally, the breakdown voltage is kept substantially constant. In this way, it can be ensured that the output power can also remain constant/continuous, so that the operation of the Marx generator can be better controlled.

It will be appreciated that various circumstances and effects can result in changes in the pressure of the pressurized gas. For example, a gas leak may result in decreasing gas pressures. A failure or malfunctioning of one or more components may also result in variations of the pressure of the pressurized gas. Additionally, gas contamination/impurities may also affect the pressure. Various physical phenomenon can influence the pressure. Another effect is the temperature. For example, electro-pulse drilling may employ a Marx generator as a high voltage generator. If for instance the Marx generator is integrated in the drill head, the temperature of the drill head may vary depending on the depth due to the geothermal phenomenon. By employing the control method and system according to the disclosure, an improved operation of the electro-pulse drilling system can be obtained. However, the control method and system according to the invention can be used in various other applications.

Optionally, the compensation unit is a passive unit, which is configured to passively compensate for effects resulting from changes in pressure of the pressurized gas. However, it is also possible that the compensation unit is an active unit that actively compensated for said effects by means of one or more sensory signals and a controller for adjusting one or more parameters such as to maintain the output power of the high voltage generator in a desired value (e.g. a preset value, a preset profile, a predetermined range, substantially constant, etc.).

According to the invention, the compensation unit comprises an adjustment mechanism configured to adjust the gap distance between the two electrodes of each of the at least two spark gap switches.

The distance between the electrodes of the spark gap switches is actively changed based upon parameters which have an influence/effect on the gas pressure of the pressurized gas/fluid provided between the electrodes of said spark gap switches.

If the breakdown voltage is too low as a result of changes in the pressure of the pressurized gas, the output of the Marx generator may be too low (cf. low power output). Advantageously, according to the disclosure, if the breakdown voltage is too low due to pressure loss, the distance between the at least two electrodes of the spark gap switches can be adjusted accordingly. In such cases, the distance between said electrodes of the spark gap switches is increased. The void distance between said electrodes is filled with pressurized gas. A compensation unit can be provided which is configured to compensate for parameters which induce changes in the pressure (e.g. by changing the distance between electrodes of spark gap switches, change of the pressure of the pressurized gas, heat/cool the pressurized gas, and/or changing the volume of pressurized gas inside the housing(s)). Advantageously, this can be performed by means of an actuation unit which is configured to change the relative distance between the electrodes, by which the breakdown voltage can be easily, accurately and reliably adjusted. Furthermore, such adjustment also provides for high response time. Pneumatic control of the pressure may be less reliable, and in some cases may be too slow.

If the breakdown voltage becomes too high as a result of changes in the pressure of the pressurized gas, the Marx generator may stop working as a result, since the capacitors cannot be charged in such a way that they would result in triggering of the spark gap switches (cf. spark generation). In such cases, the distance between the electrodes of the spark gap switches can be reduced.

Advantageously, the distance between the electrodes can be controlled and adjusted so as to obtain a breakdown voltage within a predetermined range (e.g. substantially constant). As a result, a more predictable/constant output energy can be obtained. The system and method of the disclosure can effectively compensate for variations in the pressure of the pressurized gas.

Optionally, the adjustment mechanism comprises an adjustment member which is arranged to jointly move one of the two electrodes of each spark gap switch with respect the other one of the two electrodes.

The Marx generator comprises multiple stages, each stage comprising a spark gap switch. The gap distances between the electrodes of the multiple spark gap switches may be the same or different, for example the initial distances of the multiple spark gap switching having a value in a range between 1-1.5 mm. Advantageously, during joint adjustment of the gap distances for compensating for effects resulting from changes in pressure of the pressurized gas, the relative differences between initial distances (e.g. minimal set gap distances) for the different spark gap switches can be preserved. With other words, the gap distances can be adjusted accordingly taking into account the initial configuration of the electrodes of the different spark gap switches.

According to the invention, the adjustment mechanism comprises a bellows including a surface which is resiliently responsively displaceable under the influence of pressure changes of the pressurized gas, wherein the surface is coupled to one of the two electrodes of each spark gap switch.

Optionally, the bellows is hermetically sealed. Optionally, the bellows may have underpressure (e.g. vacuum pressure) inside, which makes it less sensitive to outside parameters such as temperature variations. Optionally, the bellows is filled with a gas different than the pressurized gas filling the void between the electrodes of the spark gap switches. The used gas in the bellows may be a gas under a preset pressure which is less sensitive to temperature variations for example. If the pressure of the pressurized gas between the electrodes of the spark gap switches drops (e.g. loss of gas due to leaking), one side of the bellows may expand forward and thereby adjust and increase the gap distance between the electrodes of the spark gap switches. If the pressure of the pressurized gas between the electrodes of the spark gap switches rises (e.g. temperature increase), one side of the bellows may contract backwards and thereby adjust and decrease the gap distance between the electrodes of the spark gap switches. Such adjustment obtained by means of the bellows can be calibrated such that the distance between said electrodes are adjusted so as to keep the breakdown voltage within a predetermined range or substantially constant, even under changing conditions related to the pressure of the pressurized gas.

It will be appreciated that the bellows may be considered as a reversibly expandable body. Various alternative embodiments are envisaged.

Optionally, a bellows pressure control member is arranged to control the fluid pressure inside the bellows. The inside of the bellows may be in fluid communication with a fluid communication line through which fluid can be added or removed from the bellows, thereby allowing the pressure inside the bellows to be regulated. In this way, the output power of the Marx generator can be influenced, and if needed adjusted. For example, for electro-pulse drilling, the output power may need to be adjusted depending on the properties of the surface that is being drilled. This way, in addition to the advantageous compensation for effects resulting from changes in pressure of the pressurized gas (e.g. temperature change) performed by means of the bellows, also the output power can be accurately controlled and changed as desired.

According to the invention, the bellows is configured such that compression and expansion of the bellows results in linear movement of a rod connected to the surface of the bellows, and wherein the rod is coupled to a shaft, wherein the adjustment mechanism is arranged such that movement of the rod results in pivotal movement of the shaft, and wherein one of the two electrodes of each spark gap is connected to the shaft.

A simple mechanical solution can be obtained which can be for instance used to jointly change the distance between the electrodes. The adjustment mechanism for adjusting the distance becomes less complicated.

Optionally, the rod is coupled to the shaft via a hinge connection, wherein the position of the hinge connection is adjustable.

The hinge connection may be a connection unit arranged between the rod of the bellows and the pivotally arranged shaft. This connection unit may be configured such that a linear movement of the shaft of the bellows results in a rotation of the pivotally arranged shaft. In this example, the connection unit is configured such that an expansion of the bellows results in a clockwise movement of the pivotally arranged shaft, and that a contraction of the bellows results in a counter clockwise movement of the pivotally arranged shaft. Other mechanical arrangements are also possible. Furthermore, in this example, the connection unit has a slot in which a fixation position between the rod of the bellows and the connection unit can be adjusted. More particularly, by adjusting the fixation point, the rate of increase of the spark gap distance in function of the pressure decrease/increase can be better tuned, by adjusting the lever length. Advantageously, this can be performed for each of the individual spark gap switches.

Additionally or alternatively, this allows for easy calibration and/or finetuning of the mechanical arrangement. In this way, the initial distances between the electrodes of the individual spark gap switches can be more easily adjusted. The fixation position can be easily changed for each of the spark gap switches such that relative changes in the gap distances for the different spark gap switches can be obtained. By employing a joint movement of the pivotally arranged shaft for the multiple spark gap switches, advantageously, the adjustments of the electrode distances can be obtained whilst respecting the relative initial gap distance differences (e.g. obtained after calibration).

Optionally, the bellows is a vacuum bellows comprising a biasing member, tensioned between the surface and a wall of the bellows.

Vacuum has little or no side effects resulting from heating, ambient temperature, etc. However, it is also possible that the bellows is filled with a gas for providing a pressure which is compensated by means of a biasing member (e.g. spring), for example providing a linear movement in function of pressure changes for certain pressure ranges.

Optionally, the biasing member is a spring, wherein a biasing force induced by the spring is adjustable.

The compensation unit according to the disclosure may determine a relationship between the pressure of the pressurized gas and the breakdown voltage of the spark gap switches. A lower pressure of the pressurized gas results in lower breakdown voltage(s), which can be compensated for in an efficient and reliable way by increasing the distance between the electrodes of the spark gap switches. A higher pressure of the pressurized gas results in higher breakdown voltage(s), which can be compensated for in an efficient and reliable way by reducing the distance between the electrodes of the spark gap switches.

Optionally, the gap distance is adjusted to obtain breakdown voltage at a predetermined potential difference.

The breakdown voltage is determined by electrode geometry, electrode surface material, electrode gap distance and the gas mixture in the electrode gap. Advantageously, a stable breakdown gap voltage can be obtained by compensating for pressure changes of the pressurized gas. The output power of the Marx generator is dependent of parameters which may deviate from the setting values during the electro-pulse drilling process, which affects the output power. Such parameters may affect the pressure of the pressurized gas. The method and system according to the disclosure provides for an improved power stabilization which can ensure that a preset power will be always maintained during the process (e.g. entire drilling process when the Marx generator is used for electro-pulse drilling).

Optionally, the adjustment of the gap distance is performed at least based on a measured value indicative of a pressure of the pressurized gas.

Optionally, the adjustment of the gap distance is performed at least based on a measured temperature of the pressurized gas.

Optionally, the compensation unit comprises a pressure control module which is configured to retain the gas pressure of the pressurized gas in a predetermined range.

Optionally, the pressure control module comprises a reservoir which is in fluid communication with a chamber housing the pressurized gas, wherein changes in pressure of the pressurized gas in said chamber are compensated by means of generated fluid flow between the reservoir and the chamber.

The compensation unit can actively adjust the pressure and/or the gap distance in order to compensate for changing parameters which affect the pressure of the pressurized gas, even when the Marx generator is not easily accessible, for example under ground during a drilling process by means of an electro-pulse drill head.

If the pressure of the pressurized gas in the Marx generator changes under the influence of temperature rises or falls or due to for example small losses of the Marx generator housing/container, the compensation unit can actively compensate in order to obtain a substantially constant breakdown voltage. As a result, the Marx generator's power output can be kept stable or substantially constant.

Optionally, the Marx generator is arranged in a closed housing which is filled with the pressurized gas.

Optionally, the pressurized gas is an inert gas, for example pressurized nitrogen gas or a noble gas such as argon, helium.

Optionally, the pressure of the pressurized gas is above 1 bar. A substantially linear relationship between the breakdown voltage and the pressure can be obtained for various gases if the pressure is above 1 bar. Advantageously, such a substantially linear relationship enables a more reliable and easy control.

Optionally, the pressure of the pressurized gas is in a range between 1 to 16 bar, more preferably between 4 to 12 bar. Higher pressures of the pressurized gas may allow for a more compact design, since less distance is needed between electrodes of the spark gap switches for a same breakdown voltage. However, the components of the Marx generator which are surrounded by the gas need to be able to withstand such pressures. For example, some capacitors may break under the influence of pressures higher than 16 bar. Advantageously, in some examples, the electrodes of the spark gap switches are arranged in one or more housings (e.g. tubes) with the pressurized gas therein. In this way, other components of the Marx generator, such as capacitors, may not be in contact with the pressurized gas.

Optionally, the spark gap switches are housing in tubes with pressured gas therein. Optionally, each spark gap switch is housed in a respective tube with pressured gas therein. Optionally, the pressures of the pressured gas in the tubes of the different spark gap switches are different.

Such arrangement may result in more temperature fluctuations of the pressured gas, for example heating up as a result of sparking. As a result, the pressure can fluctuate. However, effects of the changing pressure of the pressurized gas on the breakdown voltage can be compensated for by means of the compensation unit according to the disclosure. Therefore, the compensation unit can allow a pressurized gas to be applied around the spark gap switches instead of pressurizing the entire system.

According to an aspect, the invention provides for a method of operating a Marx generator according to independent claim 12, wherein the Marx generator comprises a circuit which includes at least two capacitors which are arranged to be charged in parallel and to be discharged in series, wherein during discharge an output voltage is generated adding up a charging voltage of each of the at least two capacitors, wherein the circuit comprises at least two spark gap switches, wherein each spark gap switch comprises two electrodes separated by a gap distance which is filled with a pressurized gas, and wherein each spark gap is configured such as to allow an electric spark to pass between the electrodes in case a potential difference between the electrodes exceeds a breakdown voltage, wherein the method includes providing a compensation unit for compensating for effects resulting from changes in pressure of the pressurized gas.

Advantageously, malfunctioning of a device with a Marx generator due to temperature and/or pressure fluctuations (e.g. small temperature increase) can be prevented. For example by adjusting the gap distance (opening of pressurized gas between the electrodes of the spark gap switches) the pressure change can be compensated for. If the gap distances between the electrodes of the spark gap switches are increased, the breakdown voltages are also increased for keeping a constant breakdown voltage.

Optionally, the compensation unit comprises an adjustment mechanism with an adjustment member which is arranged to jointly move one of the two electrodes of each spark gap switch with respect the other one of the two electrodes by means of a pivotally arranged shaft connected to one of the two electrodes of each spark gap switch. However, other mechanical arrangements are also possible for moving the one of the two electrodes of each spark gap switch together, allowing to mutually adjust the distance by performing one action (e.g. one movement).

According to an aspect not covered by the invention, the disclosure provides for a compensation unit for use in a Marx generator. Advantageously, the a substantially constant desired output power of the Marx generator (e.g. 20kW pulses) can be better guaranteed, even if the pressure of the pressurized gas surrounding the electrodes of the spark gap switches would change (e.g. as a result of a leak, temperature change, etc.). For example, the pressure of the pressurized gas can increase as a result of higher temperatures, resulting in higher breakdown voltage(s). This often occurs for example for electro-pulse drilling systems (cf. geothermal heat). Without the compensation according to the disclosure, the breakdown voltage(s) and thus the power output would no longer be constant or within a predetermined range. According to some advantageous examples, the gap distance between the electrodes is automatically adjusted so as to compensate for effects resulting from changes in the pressure of the pressurized gas. In this way, the operation of the Marx generator can be significantly improved.

According to an aspect not covered by the invention, the disclosure provides for a power stabilizer for use in a Marx generator.

According to an aspect not covered by the invention, the disclosure provides for a use of the Marx generator in an electro-pulse drilling system.

According to an aspect not covered by the invention, the disclosure provides for an electro-pulse drilling system comprising a Marx generator according to the disclosure.

It will be appreciated that the Marx generator is a spark gap switched high voltage generator comprising a plurality of capacitors which are arranged such as to allow charging in parallel and discharging in series.

The circuit of the Marx generator is configured such that during charging the at least two capacitors are charged, and such that discharging occurs between the at least two spark gap switches resulting in the at least two capacitors to be connected in series, such that an output voltage is generated by adding up the charging voltage of each of the at least two capacitors. The spark gap switches may be configured to operate in a self-breakdown mode.

It will be appreciated that any of the aspects, features and options described in view of the system apply equally to the method and the described Marx generator, electro-pulse drilling system, computer program product, compensation unit and power stabilizer.

### BRIEF DESCRIPTION OF THE DRAWING

The invention will further be elucidated on the basis of exemplary embodiments which are represented in a drawing. The exemplary embodiments are given by way of non-limitative illustration. It is noted that the figures are only schematic representations of embodiments that are given by way of non-limiting example.

In the drawing:
Fig. 1a, 1b show a schematic diagram of an embodiment of a system;
Fig. 2 shows a schematic diagram of a system;
Fig. 3 shows a schematic diagram of a system;
Fig. 4 shows a schematic diagram of a system;
Fig. 5a, 5b show a schematic diagram of a system;
Fig. 6 shows a schematic diagram of a system;
Fig. 7 shows a schematic diagram of a graph;
Fig. 8 shows a schematic diagram of an electro-pulse drill head not covered by the invention; and
Fig. 9a, 9b show a schematic diagram of an electro-pulse drill head not covered by the invention.

### DETAILED DESCRIPTION

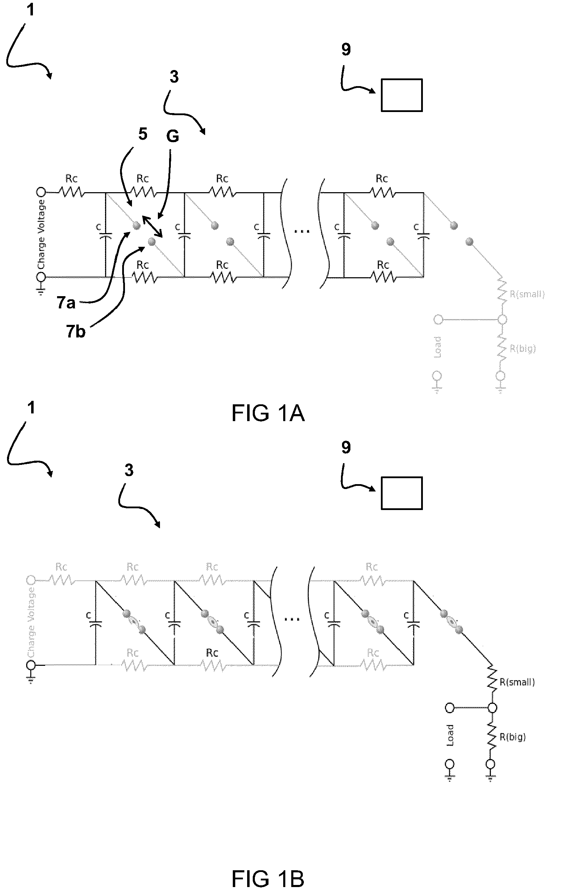

Fig. 1a, 1b show a schematic diagram of an embodiment of a system 1. The system 1 comprises a Marx generator 3 comprising a circuit that includes at least two capacitors C which are arranged to be charged in parallel and to be discharged in series, wherein during discharge an output voltage is generated adding up a charging voltage of each of the at least two capacitors C, wherein the circuit comprises at least two spark gap switches 5, wherein each spark gap switch comprises two electrodes 7a, 7b separated by a gap distance G which is filled with a pressurized gas, and wherein each spark gap switch 5 is configured to allow an electric spark to pass between its at least two electrodes 7a, 7b in case a potential difference between said two electrodes exceeds a breakdown voltage, and wherein the Marx generator includes a compensation unit 9 which is configured to compensate for effects resulting from changes in pressure of the pressurized gas. Fig. 1a shows the Marx generator in charging state, and fig. 1b shows the Marx generator in discharging state, providing an output pulse.

The circuit of the Marx generator which includes a series of capacitors C that are charged in parallel and discharged in series may have other configurations. When the capacitors C are charged, no current flows through the resistors R. If the voltage is sufficiently high, a spark can be generated between the electrodes of the spark gap switches, resulting in a series connection of the capacitors C in the circuit (see fig. 1b). The electrical current then flows from one capacitor C to the next capacitor C and so on for the subsequent stages/branches in the circuit, resulting in a high voltage pulse at the output of the Marx generator. The output is arranged at the end of the circuit. The Marx generator enables generating high voltage sparks and can be used for a wide range of applications (e.g. electric pulse drilling).

The distance between electrodes of the spark gap switches determines the breakdown voltage, i.e. the voltage required for triggering a spark between said electrodes. By compensating for parameters which result in a change of the pressure of the pressurized gas, it is possible to get a more stable output from the Marx generator. The value of the breakdown voltage determines the output voltage / output power of the Marx generator. Advantageously, the breakdown voltage is kept within a desired predetermined range (e.g. constant) by keeping the pressure of the pressurized gas within a desired predetermined range. In some advantageous examples, this is performed by adjusting the distance of the electrodes which affects the breakdown voltage. This allows for easy and reliable control of the breakdown voltage. Moreover, such adjustment mechanism can have a relatively simple design, making the Marx generator cheaper and less prone to errors.

In order to keep the Marx generator compact and stable, it may have a housing that is filled with a gas under pressure, such as for instance nitrogen gas under pressure. However, other dielectric gases may also be used, such as for instance air, CO2 gas, a noble gas, or mixtures of gases. By employing higher pressures, it is possible to have a compacter design of the Marx generator, since it is possible to obtain a greater breakdown voltage with smaller dimensions.

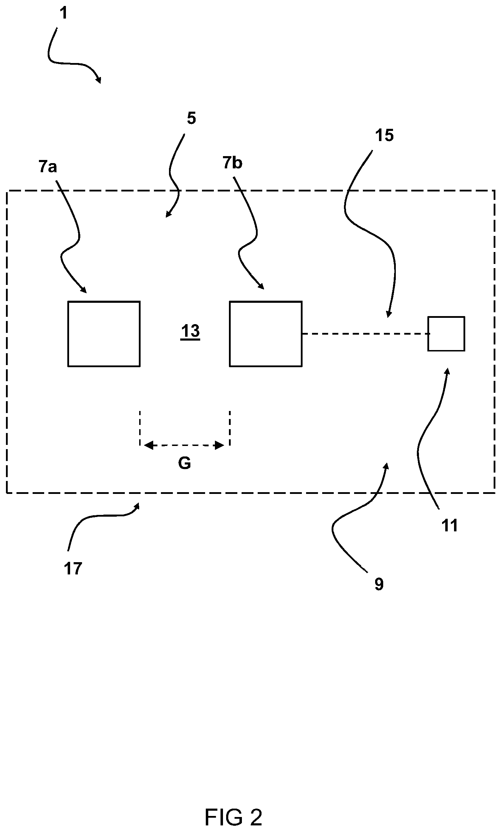

Fig. 2 shows a schematic diagram of a part of a system 1 comprising a Marx generator 3 with a compensation unit 9. The compensation unit 9 comprises an adjustment mechanism 11 configured to adjust the gap distance G between the two electrodes 7a, 7b of each of the at least two spark gap switches 5. The gap distance G is filled with a pressurized gas 13. In this example, the adjustment mechanism 11 is mechanically coupled by means of a coupling unit 15 to one of the two electrodes 7b of the at least two spark gap switches 5. In this example, the Marx generator may comprise a housing 17 in which an atmosphere of a dielectric gas prevails. The plurality of capacitor stages of the Marx generator may be arranged in said housing 17.

The Marx generator may operate more reliably and a specific power output can be guaranteed more effectively. Additionally, the durability of the Marx generator can be improved, even at high repetition rates, since the breakdown voltage can be better kept constant or within a predetermined range (e.g. +- 40 percent, +-30 percent, +-20 percent of a target value).

The mechanical adjustment of the distance between electrodes of the spark gap switches can be based on pressure measurement signals. Various types of sensors can be used for this purpose. It will be appreciated that also other sensory signals may be used which are indicative or related to the pressure of the pressurized gas.

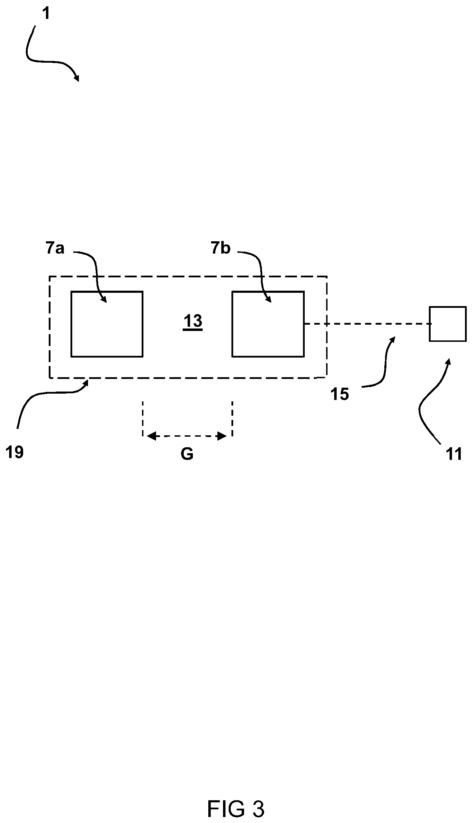

Fig. 3 shows a schematic diagram of a part of a system 1. In this example, the electrodes 7a, 7b of the spark gap switches are arranged in one or more separate housings 19. In this way, for example higher pressures may be employed whilst preventing damage to circuit elements of the Marx generator, such as for instance to the capacitors. A more compact design can be achieved in this way.

Advantageously, the Marx generator is adapted to compensate for pressure changes in order to maintain the output in a predetermined range. In some examples, the compensation is performed by means of a mechanical compensation unit arranged for adjusting the distance between electrodes of the spark gap switches. However, it is also envisaged that the compensation is performed by means of a pneumatic arrangement which is configured to maintain the pressure of the pressurized gas within a predetermined range, for example by means of a pneumatic fluid communication line. In some examples, the mechanical adjustment according to the disclosure is more advantageous, especially when the Marx generator is located in a less easily accessible place, for example in electro-pulse drilling applications.

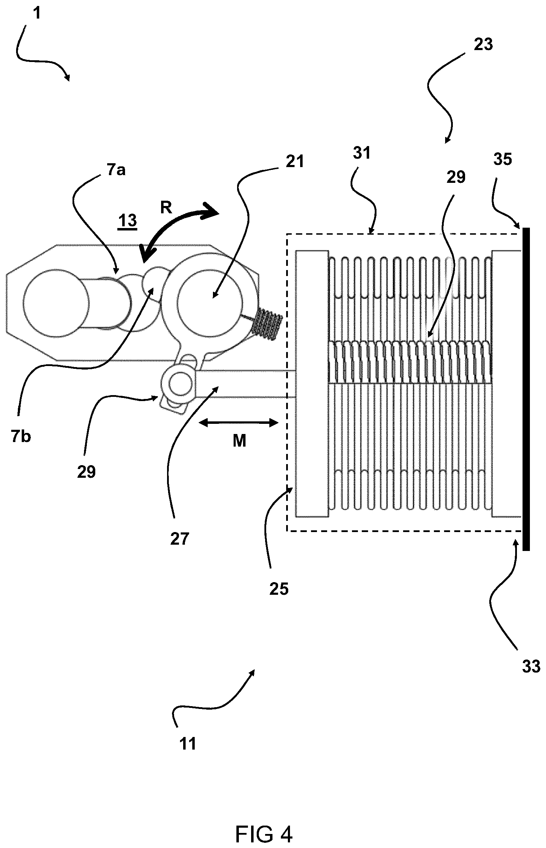

Fig. 4 shows a schematic diagram of a part of a system 1. The adjustment mechanism 11 comprises an adjustment member 21 that is arranged to jointly move one of the two electrodes 7b of each spark gap switch 5 with respect the other one of the two electrodes 7a. The adjustment mechanism 11 comprises a bellows 23 including a surface 25 which is resiliently responsively displaceable under the influence of pressure changes of the pressurized gas 13, wherein the surface is coupled to one of the two electrodes 7b of each spark gap switch 5.

The bellows 23 can be configured such that compression and expansion of the bellows 23 results in linear movement M of a rod 27 connected to said surface 25 of the bellows 23. The rod 27 can be coupled to a pivotally arranged shaft 21. The adjustment mechanism 11 can be arranged such that movement of the rod 27 results in pivotal movement of the shaft 21, indicated by rotation R in the figure. One of the two electrodes 7b of each spark gap 5 is connected to the shaft 21, so that the gap distance can be effectively and reliably adjusted. In this way, a joint movement can be easily obtained for adjusting the gap distance G based on the pressure change of the pressurized gas 13.

In this example, the rod 27 is coupled to the pivotally arranged shaft 21 via a hinge connection 29. The hinge connection 29 is configured such that the position of the connection point is adjustable.

In some examples, the bellows 23 is a vacuum bellows 23 comprising a biasing member 29 (e.g. internal compression spring), tensioned between the surface and a wall of the bellows 23. Different kinds of biasing members may be employed. Different vacuum pressures may be used in a chamber/enclosure 31 of the bellows 23. The bellows has another surface 33 at its other end which is fixed, for example mounted on a wall or surface 35. The biasing member may have an adjustable biasing force, for instance using one or more other biasing members for inducing a counter force.

Such embodiments of the disclosure allow adjustment of the gap distances for all the spark gap switches at the same time (simultaneously) without requiring a dedicated for each of the spark gap switches. A more reliable arrangement is obtained in this way. Additionally, the design of the compensation unit can be significantly simplified. For example, the multiple spark gap switches may not all have a same initial/reference gap distance, for example minimal distance between the electrodes (e.g. set by using set plates therebetween). For example, the initial/reference gap distance may be in a range between 1 and 1.5 mm for the multiple spark gap switches. For instance, the first spark gap switch in the first stage may have an initial gap distance of 1.2 mm, the second spark gap switch in the second stage may have an initial gap distance of 1.1 mm, the third spark gap switch in the third stage may have an initial gap distance of 1.4 mm, etc. By jointly changing adjusting the gap distances for the multiple spark gap switches, for example by performing a pivotal movement of the pivotally arranged shaft, the relative initial gap distances may be respected. A standard distance between electrodes of the individual spark gap switches can remain the same, however, the change of the gap distance may be the same for each of said multiple spark gap switches.

Furthermore, if the gap distance for the spark gap switches changes under the influence of vibrations, this can also have the effect of changing the breakdown voltage(s) and thus the output power of the Marx generator. Advantageously, such a mechanical arrangement of adjusting the gap distances is less sensitive to vibrations. In this way, a reliable power stabilizer can be obtained which can effectively ensure that a preset power will be maintained during use of the Marx generator (e.g. during the entire drilling process for electro-pulse drilling).

It will be appreciated that in some examples, additionally or alternatively, a fluid line may be provided to the one or more housing of the Marx generator in order to compensate for pressure changes by means of a pneumatic system (for instance including fluid reservoirs, pumps, etc.).

In some advantageous examples, the bellows comprises a hermetically sealed housing/container such that vacuum inside the bellows can be maintained longer, and therefore a more reliable and robust control arrangement can be achieved.

In some examples, the extent to which the distance between the electrodes changes as a function of a pressure variation of the pressurized gas can be adjusted by changing the pressure inside the bellows. By actively changing the pressure inside the bellows, a desired overcompensation or desired overcompensation can be obtained. As a result, a pressure variation within the bellows can also cause a power variation. Therefore, advantageously, the bellows can be employed as an output power regulator in some examples. Additionally or alternatively, also the mechanical arrangement that is configured to convert a stroke displacement into a gap distance change may be tuned for adjusting said extent to which the distance between the electrodes changes.

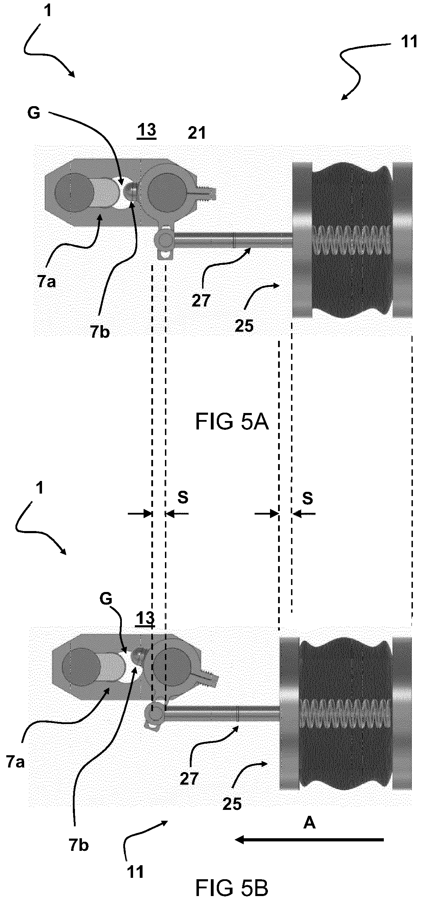

Fig. 5a, 5b show a schematic diagram of a part of a system 1. Different states of the adjustment mechanism shown in the example of fig. 4 are illustrated. Fig. 5a shows a first state in which the gap distance between the first and second electrodes 7a, 7b of the spark gap switch is minimal. Fig. 5b shows a second state in which the moveable surface 25 of the bellows 23 has been displaced as result of a changing pressure of the pressurized gas 13. As a result, a linear stroke displacement S of the rod 27 is achieved resulting in a pivotal movement of the shaft 21, thereby increasing the gap distance G.

One of the two electrodes of each spark gap switch may be mounted on a pivotally arranged shaft (e.g. cylindrical shaft). The electrode on the pivotally arranged shaft may have a spherical head. A pivotal movement of the pivotally arranged shaft can result in a changing distance between the two electrodes of the spark gap switches.

If the pressure of the pressurized gas increases, the moving surface 25 of the bellows 23 is pulled back, and the pivotally arranged shaft rotates counter clockwise, and the electrode(s) arranged on said pivotally arranged shaft are positioned closer to the other electrode(s) arranged of the spark gap switch(es). As a result, the distance between the electrodes of the spark gap switch(es) becomes smaller in predictable way (cf. calibration), resulting in a shorter path to be travelled by a spark between the (at least) two electrodes. Advantageously, a reliable and accurate mechanical adjustment mechanism can be obtained, which is less prone to errors. For example, in some applications, electronics may fail or would require extensive shielding due to an aggressive electromagnetic interference (EMI) environment.

In some examples, the pressure in the bellows is adjustable such as to control the output power of the high voltage generator. For example, a pressure line may be coupled to the bellows through which the pressure inside the bellows can be changed over time. For example, the pressure inside the bellows may be increased, decreased or maintained in order to adjust the distance between electrodes of the spark gap switches, which in turn affect the output power of the voltage generator. For instance, when the high voltage generator is used in electro-pulse drilling, some surfaces (e.g. particular rock) may require a different output power for performing efficient and/or effective drilling. Additionally or alternatively, the speed of the drilling can also be controlled in this way, without requiring electrical actuators at the electro-pulse drill head. Controlling the pressure inside the bellows for adjusting the output power of the high voltage generator (cf. Marx generator) may provide for a pneumatic control which is beneficial in various applications. Electronic equipment may require excessive shielding or may be more prone to errors due to the relatively harsh conditions at the drill head during for example during the electro-pulse drilling process (cf. EMI, vibrations, high temperatures, etc.). For example, by changing the gas pressure (e.g. vacuum pressure) in the bellows, the distance between the electrodes can be accurately changed, and the output power can be effectively varied as desired.

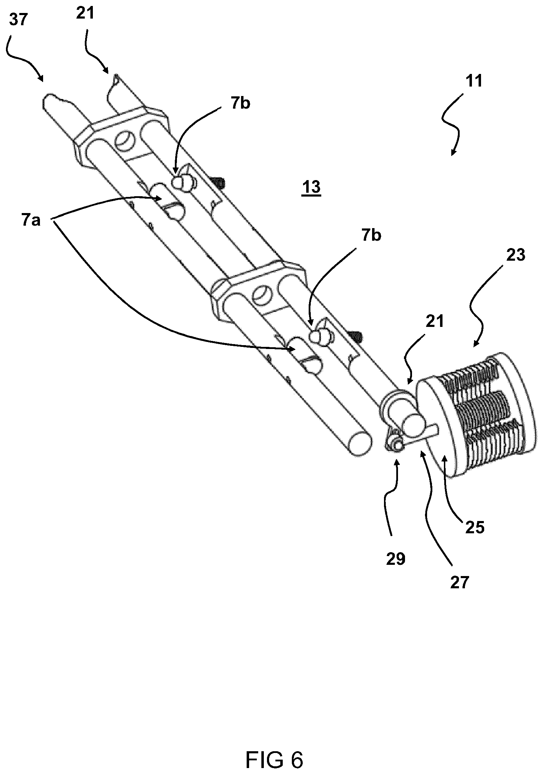

Fig. 6 shows a schematic diagram of a part of a system 1. A perspective view is shown of an adjustment mechanism 11 configured for jointly adjusting the distance between electrodes of multiple spark gap switches 5. The rotation of the shaft 21 results in joint relative movement of the electrodes 7a, 7b of the multiple spark gap switches 5.

The distance between the electrodes 7a, 7b of each of the spark gap switches 5 in the multiple stages of the Marx generator can be adjusted together using a single action. Each stage has a spark gap switch which may require a particular initial distance. The one of the two electrodes of the multiple spark gap switches of the multiple stages may be mounted on the pivotally arranged shaft. In this way, the distance between electrodes of each of the multiple spark gap switches can be jointly adjusted, whilst respecting the initial distance between electrodes for each of the multiple spark gap switches. The initial distance may be a result of calibration for example. With other words, the electrode distance of the multiple spark gap switches can be adjusted with one movement. This provides for a highly reliable adjustment mechanism for compensating for the effects resulting from changes in pressure of the pressurized gas.

Advantageously, the adjustable spark gap switches may provide for increased reliability, repetition rate, and lifetime between maintenance cycles.

Optionally, a vacuum bellows is employed. As a result, advantageously, the operation of the bellows is no longer dependent on changes of the surrounding/ambient temperature which would cause pressure changes of the gas inside the bellows. However, it is also possible to use a bellows with a predetermined gas inside.

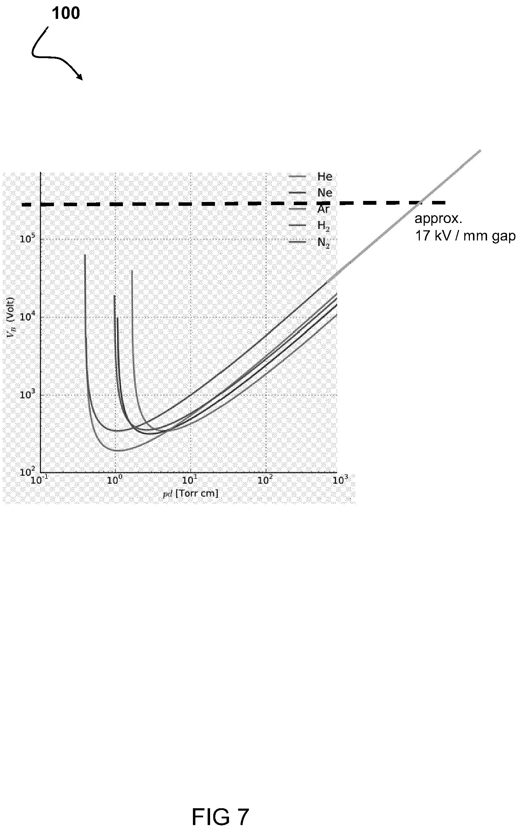

Fig. 7 shows a schematic diagram of a graph 100. The graph 100 indicates the breakdown voltage in function of the pressure of the pressurized gas for different gases. According to Paschen's law, at constant temperature in a uniform field the sparking potential of gas depends only upon the product of gas pressure and electrode spacing. With other words, the sparking potential is function of the product of both pressure and distance and is neither dependent on pressure alone nor distance alone, i.e. Vₛ = f(pd). Such Vₛ-pd curve can be given for different gases as illustrated in the figure. As already mentioned, different dielectric gases can be employed in the Marx generator.

The curve has a left branch and a right branch. The right branch is substantially linear and allows for accurate control, for example for keeping the breakdown voltage substantially constant or within a predetermined range (e.g. +-10 percent from an initial value), even under changing parameters which can influence the pressure of the fluid between the electrodes of the spark gap switches. It is advantageous to use such linear part in control. As can be seen, for lower pressures, the graph is relatively steep, thus making it very sensitive to changes, resulting in a more difficult or even unreliable control in those ranges. In the figure, For example, for nitrogen gas at a pressure of 12 bar, the breakdown voltage is approximately 17 kV/mm.

If the pressure of the pressurized gas rises, the breakdown voltage rises. This is compensated for by the compensating unit by reducing the distance between the electrodes of the spark gap switches.

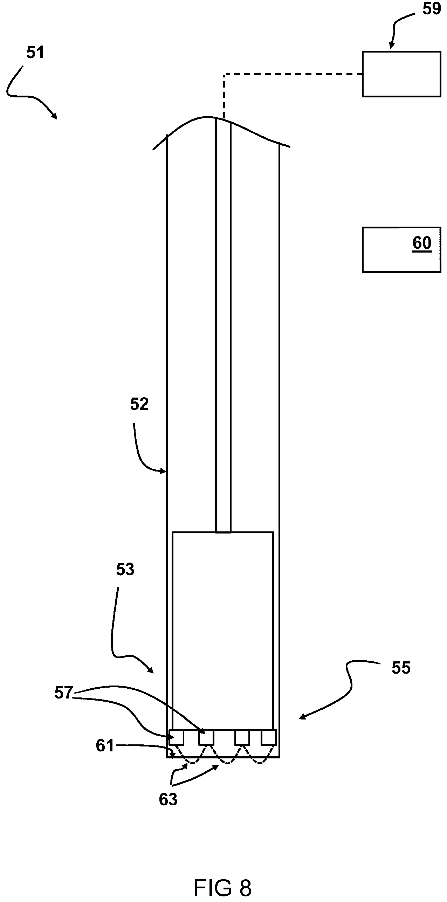

Fig. 8 shows a schematic diagram of an embodiment of an electro-pulse drilling system 5] not covered by the invention. The drilling system 51 comprises a controller 60 configured for operating the electro-pulse drilling system. The system 51 comprises a drill head 53 with an end portion 55, wherein at least two electrodes 57 are arranged at the end portion 55 of the drill head 53. The system 51 further includes an actuation system 59 configured for moving the drill head adjacent to the surface 61 to be broken up. The system 51 also includes a high voltage generator configured for applying a voltage between the electrodes 57 resulting in one or more electric discharges between the electrodes 57, the one or more discharges resulting in one or more electric arcs 63 for breaking up the surface 61. The high voltage generator is a Marx generator.

In the shown example, the drill head 53 is positioned in a drill hole 52. In some cases the voltage generated (not shown in this figure) is separated from the drill head 53. However, it is also envisaged that the voltage generator is attached to or integrated in the drill head of the drilling system 51. In some examples, the drill head 53 and the voltage generator form a unitary device, directly coupled to each other. In some examples, the drill head 53 and the voltage generator are separated and can be positioned remotely with respect to each other, for instance coupled by means of wiring. In some examples, the drill head 53 and the voltage generator are separated such as to allow movement with respect to each other. Many types of arrangements are possible.

It will be appreciated that the front end of the drill head 53 is not necessarily a flat face containing electrodes 57 extending therefrom. The front end may only include protruding electrodes (e.g. rods with electrode end portions). Between the protruding electrodes 57, sufficient spacing may be provided to as to allow debris to be evacuated by means of flushing.

An electro-pulse drilling installation with a Marx high voltage generator may require that the components of the Marx generator are built into in a closed housing which is filled with a gas at a preset pressure (e.g. dry nitrogen gas under pressure). The preset pressure may be chosen sufficiently high in order to keep the dimensions of the housing limited. The pressure of the pressurized gas in the housing determines the breakdown voltage (kV/cm) and therefore also the mutual distance between the various components. A higher pressure of the pressured gas results in higher breakdown voltage for the spark gap switches. Additionally, the spark gap switches may be arranged in a same housing in which the pressurized gas prevails. Advantageously, the compensation unit is provided for compensating for changes in the pressure. In some advantageous examples, the gap distance is adjusted in order to achieve breakdown (cf. triggering of the spark gap switches) at a certain breakdown voltage. The spark gap switches can also be mounted in a separate housing (e.g. one or more tubes) with a separate pressurized gas (e.g. all at same or different pressures).

The Marx generator may be integrated into the electro-pulse drill head body or built externally. In both cases, the compensation unit according to the disclosure may be arranged in the Marx generator.

The breakdown voltage of the spark gap switches may be determined by the gas pressure, and thus the available power output of the Marx generator at the electro-pulse drill head also depends on this. Furthermore, the gas pressure of the pressurized gas also depends on the temperature of the pressurized gas. The temperature of the pressurized gas in the electro-pulse drill head may change significantly during (deep) electro-pulse drilling operations (e.g. due to geothermal heat), which can significantly change the breakdown voltage(s) and thus the output power. The compensation unit according to the disclosure can prevent such changes of the breakdown voltage(s) and the output power.

The compensation unit can provide for an effective and reliable power regulation. Pressure changes of the pressurized gas at the electrodes of the spark gap switches in the Marx generator in the housing(s) can be captured. For this purpose one or more sensors may be used which can capture indicative of the pressure of the pressurized gas. In some examples, the gap distance between the electrode pairs of the spark gap switches is adjusted based on said changing pressures. For example, the pressure changes may be induced as a result of loss of gas over time from the Marx generator (e.g. leak, bad packaging, etc.); temperature changes of the gas in the Marx generator for instance due to environmental conditions; and/or any other cause.

In some examples, the compensation unit comprises a bellows according to the disclosure. In some examples, the bellows is a bellows with a gas chamber. Optionally, the gas chamber is in fluid communication with an external unit by means of a fluid line. For example, the line may be connected to a pump for obtaining vacuum in the bellows. Alternatively, it is also possible that the bellows comprises a hermetically sealed gas chamber such that vacuum inside the bellows can be maintained longer without the need of pumps or the like. One side of the bellows may be fixedly mounted on a structure. The other side may be allowed to move. In the chamber of the bellows, a compression spring may be mounted. A biasing force of the compression spring can be adjusted to a reference gas pressure in the Max generator. The expansion or compression of this compression spring may be tuned such that a linear movement of the other side is obtained when the pressure is changed within a predetermined pressure range.

By using vacuum in the bellows (cf. significant under pressure), tuning and setting of the bellows becomes easier and substantially independent of ambient temperatures. Therefore, a more predictable and reliable adjustment mechanism can be obtained in this way. Only a small error due to mechanical expansion of the body of the bellows over the temperature range may be obtained. The compression or expansion of the bellows may be substantially linearly transferred with a rod to an eccentric rotating shaft. One electrode of the spark gap switch may be mounted on this rotating shaft. This rotating shaft increases or decreases the opening of the spark gap switch(es) (cf. gap distance between its electrodes) based on the gas pressure of the pressurized gas surrounding said spark gap switch(es). The adjustment can be performed jointly by arranging one electrode of multiple spark gap switches on this rotating shaft. The rotation of the rotating shaft results in a joint movement of one of the electrodes of the multiple spark gap switches. Advantageously, in such examples, no external piping or fluid communication may be required. Furthermore, in some examples, the bellows may be configured to retain a vacuum pressure. The bellows may be connected to a vacuum pump for obtaining a vacuum pressure inside, and then a valve may be used for retaining vacuum inside the chamber of the bellows. For instance, in case of electro-pulse drilling, no vacuum pump may be required during the drilling cycle itself in this way. Hence, a relatively compact design can be achieved.

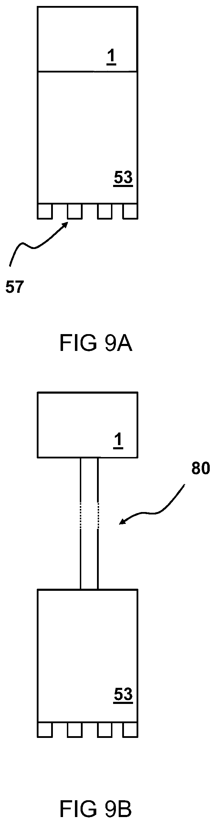

Fig. 9a and 9b show a schematic diagram of an embodiment of drill head 53 not covered by the invention. In fig. 9a, a voltage generator 1 is integrated within the drill head 53. In fig. 9b, the voltage generator 1 is distanced from the drill head 53. The distance between the voltage generator 1 and the drill head 53 may be adjustable in this example, for example the distance may be increased when the drill head 53 is lowered further in the bore hole during the electro-pulse drilling process. The voltage generator 1 and the drill head 53 may be coupled by means of a coupling member 80.

The pressure of the pressurized gas can increase for example due to geothermal energy at certain depths. It is also possible that the temperature changes due to the operation of the electro-pulse drilling head. For example, internal heating can also affect the temperature of the pressurized gas. An increased pressure resulting from an increased temperature will cause an increase of the breakdown voltage(s). Without the compensation unit according to the disclosure, at a certain point the electro-pulse drilling head would stop working. Therefore, by employing the method and system according to disclosure, the electro-pulse drilling head with Marx generator can be employed for greater depths, countering detrimental effects a.o. resulting from geothermal heating.

By employing higher pressures for the pressurized gas, a more compact design can be achieved. In this way, for example smaller electro-pulse drilling heads can be obtained. However, larger pressures may be more sensitive to effects such as temperature changes, gas leaks, etc. Various gases can be employed in the Marx generator. The gas may be a dielectric gas. For example, the gas may be dry nitrogen gas (cf. highly electrically insulating gas). However, it is also possible to use other gases (e.g. noble gases). In some examples, it is desired to have a gas which has a breakdown voltage larger than 1000Volt/mm at a pressure of 1 atm. Various dielectric gases can be used. Examples of other gases which can be used are argon, helium, natrium, sulphur hexa-fluoride, air, CO2 gas, etc.

It will be appreciated that various vacuum pressures can be employed inside the bellows. Optionally, the vacuum pressure is smaller than 0.1 bar. In some examples, the vacuum pressure is smaller than 0.01 bar. In some example, the effect of temperature is even further reduced by employing a vacuum pressure of 0.001 bar or even lower. The selection of the vacuum pressure may highly depend on the application in which the Marx generator is being employed. The temperature of the pressurized gas may for example be elevated to higher temperatures as a result of geothermal heat during electro-pulse drilling. The vacuum pressure may be selected such as to reduce the effect of the elevated temperatures on the stroke displacement, thereby providing for a more robust and accurate control. The vacuum pressure may be selected such that the temperature variations result in deviations which fall within the resolution of the control arrangement.

In some examples, the pressure of the bellows is related to the pressure of the pressurized gas. Optionally, the pressure inside the bellows is at least 10 times smaller than the pressure of the pressurized gas, more preferably at least 20 times smaller, even more preferably at least 30 times smaller.

It will be appreciated that a spark gap switch may be understood as a spark switch or a spark electrode switch.

It will be appreciated that electro-pulse drilling may also be understood as electrical-pulse drilling, electrical arc drilling, electro-crushing drilling, pulsed arc plasma drilling, pulsating arc drilling, plasma arc drilling, plasma pulse drilling, plasma pulse geo-drilling, etc. The term "drilling" along with its derivatives, may be replaced with "boring" and vice versa. The term can be interpreted as an action of making a hole, cutting or making an indentation or the like, in some surface or material. The term drilling or boring may imply that pieces of the surface or material are broken up and are removed from the drilling zone during the drilling process.

It will be appreciated that the gap distance may be considered as an interspace, a separation, a clearance, a split, a spacing, or a void between the electrodes of the spark gap switches.

In the following description and claims, the term "coupled" along with its derivatives, may be used. "Coupled" is used to indicate that two or more elements co-operate or interact with each other, but they may or may not have intervening physical or electrical components between them.

As used in the claims, unless otherwise specified the use of the ordinal adjectives "first", "second", "third", etc., to describe a common element, merely indicate that different instances of like elements are being referred to, and are not intended to imply that the elements so described must be in a given sequence, either temporally, spatially, in ranking, or in any other manner. The drawings and the forgoing description give examples of embodiments. Those skilled in the art will appreciate that one or more of the described elements may well be combined into a single functional element. Alternatively, certain elements may be split into multiple functional elements.

The term "about" or "approximately" as used herein when referring to a measurable value such as a parameter, an amount, a temporal duration, and the like, is meant to encompass variations of +/-10 % or less, preferably +/-5 % or less, more preferably +/- 1% or less, and still more preferably +/-0.1 % or less of and from the specified value, insofar such variations are appropriate to perform in the disclosed invention. It is to be understood that the value to which the modifier "about" or "approximately" refers is itself also specifically, and preferably, disclosed.

It will be appreciated that the method may include computer implemented steps. All above mentioned steps can be computer implemented steps. Embodiments may comprise computer apparatus, wherein processes performed in computer apparatus. The disclosure also extends to computer programs, particularly computer programs on or in a carrier, adapted for putting the invention into practice. The program may be in the form of source or object code or in any other form suitable for use in the implementation of the processes according to the invention. The carrier may be any entity or device capable of carrying the program. For example, the carrier may comprise a storage medium, such as a ROM, for example a semiconductor ROM or hard disk. Further, the carrier may be a transmissible carrier such as an electrical or optical signal which may be conveyed via electrical or optical cable or by radio or other means, e.g. via the internet or cloud.

Some embodiments may be implemented, for example, using a machine or tangible computer-readable medium or article which may store an instruction or a set of instructions that, if executed by a machine, may cause the machine to perform a method and/or operations in accordance with the embodiments.

Various embodiments may be implemented using hardware elements, software elements, or a combination of both. Examples of hardware elements may include processors, microprocessors, circuits, application specific integrated circuits (ASIC), programmable logic devices (PLD), digital signal processors (DSP), field programmable gate array (FPGA), logic gates, registers, semiconductor device, microchips, chip sets, et cetera. Examples of software may include software components, programs, applications, computer programs, application programs, system programs, machine programs, operating system software, mobile apps, middleware, firmware, software modules, routines, subroutines, functions, computer implemented methods, procedures, software interfaces, application program interfaces (API), methods, instruction sets, computing code, computer code, et cetera.

Herein, the invention is described with reference to specific examples of embodiments of the invention. It will, however, be evident that various modifications, variations, alternatives and changes may be made therein, without departing from the scope of the invention. For the purpose of clarity and a concise description features are described herein as part of the same or separate embodiments, however, alternative embodiments having combinations of all or some of the features described in these separate embodiments are also envisaged and understood to fall within the framework of the invention as outlined by the claims. The specifications, figures and examples are, accordingly, to be regarded in an illustrative sense rather than in a restrictive sense. The invention is intended to embrace all alternatives, modifications and variations which fall within the scope of the appended claims. Further, many of the elements that are described are functional entities that may be implemented as discrete or distributed components or in conjunction with other components, in any suitable combination and location.

In the claims, any reference signs placed between parentheses shall not be construed as limiting the claim. The word 'comprising' does not exclude the presence of other features or steps than those listed in a claim. Furthermore, the words 'a' and 'an' shall not be construed as limited to 'only one', but instead are used to mean 'at least one', and do not exclude a plurality. The mere fact that certain measures are recited in mutually different claims does not indicate that a combination of these measures cannot be used to an advantage.

## Claims

1. A Marx generator (3) comprising a circuit which includes at least two capacitors (C) which are arranged to be charged in parallel and to be discharged in series, wherein during discharge an output voltage is generated adding up a charging voltage of each of the at least two capacitors (C), wherein the circuit comprises at least two spark gap switches (5), wherein each spark gap switch (5) comprises two electrodes (7a, 7b) separated by a gap distance (G) which is filled with a pressurized gas, and wherein each spark gap switch (5) is configured to allow an electric spark to pass between its two electrodes (7a, 7b) in case a potential difference between said two electrodes exceeds a breakdown voltage, and wherein the Marx generator includes a compensation unit (9) which is configured to compensate for effects resulting from changes in pressure of the pressurized gas, wherein the compensation unit (9) comprises an adjustment mechanism configured to adjust the gap distance (G) between the two electrodes (7a, 7b) of each of the at least two spark gap switches (5), wherein the adjustment mechanism comprises a bellows (23) including a surface (25) which is resiliently responsively displaceable under the influence of pressure changes of the pressurized gas (13), and wherein the surface (25) is coupled to one of the two electrodes (7a, 7b) of each spark gap switch (5);
**characterized in that**
the bellows (23) is configured such that compression and expansion of the bellows (23) results in linear movement of a rod (27) connected to the surface (25) of the bellows (23), and wherein the rod (27) is coupled to a shaft (21), wherein the adjustment mechanism is arranged such that movement of the rod (27) results in pivotal movement of the shaft (21),
and wherein one of the two electrodes (7a, 7b) of each spark gap (5) is connected to the shaft (21).

2. The Marx generator of claim 1, wherein the adjustment mechanism comprises an adjustment member which is arranged to jointly move one of the two electrodes (7a, 7b) of each spark gap switch (5) with respect the other one of the two electrodes (7a, 7b).

3. The Marx generator of any one of the preceding claims, wherein a bellows pressure control member is arranged to control the fluid pressure inside the bellows (23).

4. The Marx generator of any one of the preceding claims, wherein the rod (27) is coupled to the shaft (21) via a hinge connection (29), wherein the position of the hinge connection (29) is adjustable.

5. The Marx generator of any one of the preceding claims, wherein the bellows (23) is a vacuum bellows comprising a biasing member (29), tensioned between the surface (25) and a wall of the bellows (23).

6. The Marx generator of claim 5, wherein the biasing member (29) is a spring, wherein a biasing force induced by the spring is adjustable.

7. The Marx generator of any one of the preceding claims, wherein the gap distance (G) is adjusted to obtain breakdown voltage at a predetermined potential difference.

8. The Marx generator of claim 7, wherein the adjustment of the gap distance (G) is performed at least based on a measured value indicative of a pressure of the pressurized gas (13).

9. The Marx generator of claim 7 or 8, wherein the adjustment of the gap distance (G) is performed at least based on a measured temperature of the pressurized gas (13).

10. The Marx generator of any one of the preceding claims, wherein the compensation unit (9) comprises a pressure control module which is configured to retain the gas pressure of the pressurized gas (13) in a predetermined range.

11. The Marx generator of claim 10, wherein the pressure control module comprises a reservoir which is in fluid communication with a chamber housing the pressurized gas (13), wherein changes in pressure of the pressurized gas in said chamber are compensated by means of generated fluid flow between the reservoir and the chamber.

12. A method of operating a Marx generator (3), wherein the Marx generator (3) comprises a circuit which includes at least two capacitors (C) which are arranged to be charged in parallel and to be discharged in series, wherein during discharge an output voltage is generated adding up a charging voltage of each of the at least two capacitors (C), wherein the circuit comprises at least two spark gap switches (5), wherein each spark gap switch (5) comprises two electrodes (7a, 7b) separated by a gap distance (G) which is filled with a pressurized gas (13), and wherein each spark gap is configured such as to allow an electric spark to pass between the electrodes in case a potential difference between the electrodes exceeds a breakdown voltage, wherein the method includes providing a compensation unit (9) for compensating for effects resulting from changes in pressure of the pressurized gas, wherein the compensation unit (9) is provided with an adjustment mechanism configured to adjust the gap distance (G) between the two electrodes (7a, 7b) of each of the at least two spark gap switches (5), wherein the adjustment mechanism is provided with a bellows (23) including a surface (25) which is resiliently responsively displaceable under the influence of pressure changes of the pressurized gas (13), and wherein the surface (25) is coupled to one of the two electrodes (7a, 7b) of each spark gap switch (5), **characterized in that** the bellows (23) is configured such that compression and expansion of the bellows (23) results in linear movement of a rod (27) connected to the surface (25) of the bellows (23), and wherein the rod (27) is coupled to a shaft (21), wherein the adjustment mechanism is arranged such that movement of the rod (27) results in pivotal movement of the shaft (21), and wherein one of the two electrodes (7a, 7b) of each spark gap (5) is connected to the shaft (21).

## Patentansprüche

1. Marx-Generator (3)mit einer Schaltung, die mindestens zwei Kondensatoren (C) enthält, die so angeordnet sind, dass sie parallel geladen und in Reihe entladen werden, wobei während der Entladung eine Ausgangsspannung erzeugt wird, die sich aus der Summe der Ladespannungen jedes der mindestens zwei Kondensatoren (C) ergibt, wobei die Schaltung mindestens zwei Funkenstreckenschalter (5) aufweist, wobei jeder Funkenstreckenschalter (5) zwei Elektroden (7a, 7b) aufweist, die durch einen mit einem unter Druck stehenden Gas gefüllten Spaltabstand (G) voneinander getrennt sind, und wobei jeder Funkenstreckenschalter (5) so konfiguriert ist, dass er den Durchgang eines elektrischen Funkens zwischen seinen beiden Elektroden (7a, 7b) zulässt, falls eine Potentialdifferenz zwischen den beiden Elektroden eine Durchbruchspannung überschreitet, und wobei der Marx-Generator eine Kompensationseinheit (9) aufweist, die so angeordnet ist, dass sie Auswirkungen kompensiert, die sich aus Druckänderungen des unter Druck stehenden Gases ergeben, wobei die Kompensationseinheit (9) einen Anpassungsmechanismus aufweist, der so angeordnet ist, dass er den Spaltabstand (G) zwischen den beiden Elektroden (7a, 7b) jedes der mindestens zwei Funkenstreckenschalter (5) anpasst, wobei der Anpassungsmechanismus einen Balg (23) aufweist, mit einer Oberfläche (25), die unter dem Einfluss von Druckänderungen des unter Druck stehenden Gases (13) elastisch reaktionsfähig verschiebbar ist, und wobei die Oberfläche (25) mit einer der beiden Elektroden (7a, 7b) jedes Funkenstreckenschalters (5) gekoppelt ist;
**dadurch gekennzeichnet,**
**dass** der Balg (23) so ausgebildet ist, dass das Zusammenziehen und Ausdehnen des Balgs (23) zu einer linearen Bewegung einer Stange (27) führt, die mit der Oberfläche (25) des Balgs (23) verbunden ist, und wobei die Stange (27) mit einer Welle (21) gekoppelt ist, wobei der Anpassungsmechanismus so angeordnet ist, dass die Bewegung der Stange (27) zu einer Drehbewegung der Welle (21) führt,
und wobei eine der beiden Elektroden (7a, 7b) jedes Funkenstreckenschalters (5) mit der Welle (21) verbunden ist.

2. Marx-Generator nach Anspruch 1, wobei der Anpassungsmechanismus ein Anpassungselement aufweist, das so angeordnet ist, dass es eine der beiden Elektroden (7a, 7b) jedes Funkenstreckenschalters (5) gemeinsam mit der anderen der beiden Elektroden (7a, 7b) bewegt.

3. Marx-Generator nach einem der vorhergehenden Ansprüche, wobei ein Balgdruckregelungselement zur Regelung des Fluiddrucks im Balg (23) angeordnet ist.

4. Marx-Generator nach einem der vorhergehenden Ansprüche, wobei die Stange (27) über eine Scharnierverbindung (29) mit der Welle (21) gekoppelt ist, wobei die Position der Scharnierverbindung (29) verstellbar ist.

5. Marx-Generator nach einem der vorhergehenden Ansprüche, wobei der Balg (23) ein Vakuumbalg ist, der ein Vorspannelement (29) aufweist, das zwischen der Oberfläche (25) und einer Wand des Balgs (23) gespannt ist.

6. Marx-Generator nach Anspruch 5, wobei das Vorspannelement (29) eine Feder ist und die von der Feder erzeugte Vorspannkraft verstellbar ist.

7. Marx-Generator nach einem der vorhergehenden Ansprüche, wobei der Spaltabstand (G) so angepasst wird, dass eine Durchbruchspannung bei einer vorgegebenen Potentialdifferenz erzielt wird.

8. Marx-Generator nach Anspruch 7, wobei die Anpassung des Spaltabstands (G) zumindest auf der Grundlage eines Messwerts erfolgt, der einen Druck des unter Druck stehenden Gases (13) angibt.

9. Marx-Generator nach Anspruch 7 oder 8, wobei die Anpassung des Spaltabstandes (G) zumindest auf der Grundlage einer gemessenen Temperatur des unter Druck stehenden Gases (13) erfolgt.

10. Marx-Generator nach einem der vorhergehenden Ansprüche, wobei die Kompensationseinheit (9) ein Druckregelungsmodul aufweist, das so angeordnet ist, dass es den Gasdruck des unter Druck stehenden Gases (13) in einem vorbestimmten Bereich hält.

11. Marx-Generator nach Anspruch 10, wobei das Druckreglungsmodul ein Reservoir aufweist, das in Fluidverbindung mit einer Kammer steht, in der das unter Druck stehende Gas (13) untergebracht ist, wobei Druckänderungen des unter Druck stehenden Gases in der Kammer durch einen erzeugten Fluidstrom zwischen dem Reservoir und der Kammer kompensiert werden.

12. Verfahren zum Betreiben eines Marx-Generators (3), wobei der Marx-Generator (3) eine Schaltung aufweist, die mindestens zwei Kondensatoren (C) enthält, die so angeordnet sind, dass sie parallel geladen und in Reihe entladen werden, wobei während der Entladung eine Ausgangsspannung erzeugt wird, die sich aus der Summe der Ladespannungen jedes der mindestens zwei Kondensatoren (C) ergibt, wobei die Schaltung mindestens zwei Funkenstreckenschalter (5) aufweist, wobei jeder Funkenstreckenschalter (5) zwei Elektroden (7a, 7b) aufweist, die durch einen mit einem unter Druck stehenden Gas (13) gefüllten Spaltabstand (G) voneinander getrennt sind, und wobei jeder Funkenstreckenschalter (5) so konfiguriert ist, dass er den Durchgang eines elektrischen Funkens zwischen den Elektroden zulässt, falls eine Potentialdifferenz zwischen den Elektroden eine Durchbruchspannung überschreitet, wobei das Verfahren das Bereitstellen einer Kompensationseinheit (9) zum Kompensieren von Effekten umfasst, die aus sich aus Druckänderungen des unter Druck stehenden Gases ergeben, wobei die Kompensationseinheit (9) mit einem Anpassungsmechanismus versehen ist, der so konfiguriert ist, dass er den Spaltabstand (G) zwischen den beiden Elektroden (7a, 7b) jedes der mindestens zwei Funkenstufenschalter (5) anpasst, wobei der Anpassungsmechanismus mit einem Balg (23) versehen ist, der eine Oberfläche (25) aufweist, die unter dem Einfluss von Druckänderungen des unter Druck stehenden Gases (13) elastisch nachgiebig verschiebbar ist, und wobei die Oberfläche (25) mit einer der beiden Elektroden (7a, 7b) jedes Funkenstreckenschalters (5) gekoppelt ist,
**dadurch gekennzeichnet, dass** der Balg (23) so ausgebildet ist, dass das Zusammenziehen und Ausdehnen des Balgs (23) zu einer linearen Bewegung einer Stange (27) führt, die mit der Oberfläche (25) des Balgs (23) verbunden ist, und wobei die Stange (27) mit einer Welle (21) verbunden ist, wobei der Anpassungsmechanismus so angeordnet ist, dass die Bewegung der Stange (27) zu einer Drehbewegung der Welle (21) führt,
und wobei eine der beiden Elektroden (7a, 7b) jedes Funkenstreckenschalters (5) mit der Welle (21) verbunden ist.

## Revendications

1. Générateur de Marx (3) comprenant un circuit qui comporte au moins deux condensateurs (C) qui sont agencés pour être chargés en parallèle et pour être déchargés en série, dans lequel, pendant la décharge, une tension de sortie est générée en additionnant une tension de charge de chacun des au moins deux condensateurs (C), dans lequel le circuit comprend au moins deux commutateurs à éclateur (5), dans lequel chaque commutateur à éclateur (5) comprend deux électrodes (7a, 7b) séparées d'une distance d'espacement (G) qui est remplie d'un gaz sous pression, et dans lequel chaque commutateur à éclateur (5) est configuré pour permettre le passage d'une étincelle électrique entre ses deux électrodes (7a, 7b) dans le cas où une différence de potentiel entre lesdites deux électrodes dépasse une tension de claquage, et dans lequel le générateur de Marx comporte une unité de compensation (9) qui est configurée pour compenser les effets résultant des variations de pression du gaz sous pression, dans lequel l'unité de compensation (9) comprend un mécanisme de réglage configuré pour régler la distance d'espacement (G) entre les deux électrodes (7a, 7b) de chacun des au moins deux commutateurs à éclateur (5), dans lequel le mécanisme de réglage comprend un soufflet (23) comportant une surface (25) qui est mobile élastiquement en réaction à l'influence de variations de pression du gaz sous pression (13), et dans lequel la surface (25) est couplée à l'une des deux électrodes (7a, 7b) de chaque commutateur à éclateur (5) ;
**caractérisé en ce que**
le soufflet (23) est configuré de sorte que la compression et la dilatation du soufflet (23) entraînent un mouvement linéaire d'une tige (27) connectée à la surface (25) du soufflet (23), et dans lequel la tige (27) est couplée à un arbre (21), dans lequel le mécanisme de réglage est agencé de sorte que le mouvement de la tige (27) donne lieu à un mouvement pivotant de l'arbre (21), et dans lequel l'une des deux électrodes (7a, 7b) de chaque éclateur (5) est connectée à l'arbre (21).

2. Générateur de Marx selon la revendication 1, dans lequel le mécanisme de réglage comprend un élément de réglage qui est agencé pour déplacer conjointement l'une des deux électrodes (7a, 7b) de chaque commutateur à éclateur (5) par rapport à l'autre des deux électrodes (7a, 7b).

3. Générateur de Marx selon l'une des revendications précédentes, dans lequel un élément de régulation de pression de soufflet est agencé pour réguler la pression de fluide à l'intérieur du soufflet (23).

4. Générateur de Marx selon l'une des revendications précédentes, dans lequel la tige (27) est couplée à l'arbre (21) via une connexion articulée (29), dans lequel la position de la connexion articulée (29) est réglable.

5. Générateur de Marx selon l'une des revendications précédentes, dans lequel le soufflet (23) est un soufflet à vide comprenant un élément de sollicitation (29) tendu entre la surface (25) et une paroi du soufflet (23).

6. Générateur de Marx selon la revendication 5, dans lequel l'élément de sollicitation (29) est un ressort, dans lequel une force de sollicitation induite par le ressort est réglable.

7. Générateur de Marx selon l'une des revendications précédentes, dans lequel la distance d'espacement (G) est réglée de manière à obtenir une tension de claquage à une différence de potentiel prédéterminée.

8. Générateur de Marx selon la revendication 7, dans lequel le réglage de la distance d'espacement (G) est effectué en se basant au moins sur une valeur mesurée indicative d'une pression du gaz sous pression (13).

9. Générateur de Marx selon la revendication 7 ou 8, dans lequel le réglage de la distance d'espacement (G) est effectué en se basant au moins sur une température mesurée du gaz sous pression (13).

10. Générateur de Marx selon l'une des revendications précédentes, dans lequel l'unité de compensation (9) comprend un module de régulation de pression qui est configuré pour maintenir la pression de gaz du gaz sous pression (13) dans une plage prédéterminée.

11. Générateur de Marx selon la revendication 10, dans lequel le module de régulation de pression comprend un réservoir qui est en communication fluidique avec une chambre contenant le gaz sous pression (13), dans lequel les variations de pression du gaz sous pression dans ladite chambre sont compensées au moyen d'un écoulement de fluide généré entre le réservoir et la chambre.

12. Procédé de fonctionnement d'un générateur de Marx (3), dans lequel le générateur de Marx (3) comprend un circuit qui comporte au moins deux condensateurs (C) qui sont agencés pour être chargés en parallèle et pour être déchargés en série, dans lequel, pendant la décharge, une tension de sortie est générée en additionnant une tension de charge de chacun des au moins deux condensateurs (C), dans lequel le circuit comprend au moins deux commutateurs à éclateur (5), dans lequel chaque commutateur à éclateur (5) comprend deux électrodes (7a, 7b) séparées d'une distance d'espacement (G) qui est remplie d'un gaz sous pression (13), et dans lequel chaque commutateur à éclateur (5) est configuré de manière à permettre le passage d'une étincelle électrique entre les électrodes dans le cas où une différence de potentiel entre les électrodes dépasse une tension de claquage, dans lequel le procédé comporte la fourniture d'une unité de compensation (9) destinée à compenser les effets résultant des variations de pression du gaz sous pression, dans lequel l'unité de compensation (9) est pourvue d'un mécanisme de réglage configuré pour régler la distance d'espacement (G) entre les deux électrodes (7a, 7b) de chacun des au moins deux commutateurs à éclateur (5), dans lequel le mécanisme de réglage est pourvu d'un soufflet (23) comportant une surface (25) qui est mobile élastiquement en réaction à l'influence de variations de pression du gaz sous pression (13), et dans lequel la surface (25) est couplée à l'une des deux électrodes (7a, 7b) de chaque commutateur à éclateur (5), **caractérisé en ce que**
le soufflet (23) est configuré de sorte que la compression et la dilatation du soufflet (23) entraînent un mouvement linéaire d'une tige (27) connectée à la surface (25) du soufflet (23), et dans lequel la tige (27) est couplée à un arbre (21), dans lequel le mécanisme de réglage est agencé de sorte que le mouvement de la tige (27) donne lieu à un mouvement pivotant de l'arbre (21), et dans lequel l'une des deux électrodes (7a, 7b) de chaque éclateur (5) est connectée à l'arbre (21).
